(19) Europäisches Patentamt / European Patent Office / Office européen des brevets

(11) **EP 1 971 023 B1**

(12) **EUROPEAN PATENT SPECIFICATION**

(45) Date of publication and mention
of the grant of the patent:
**01.05.2019 Bulletin 2019/18**

(51) Int Cl.:
*H03F 1/32* *(2006.01)*    *H03F 3/217* *(2006.01)*
*H03K 7/08* *(2006.01)*    *H03K 17/16* *(2006.01)*
*H03F 1/26* *(2006.01)*

(21) Application number: **07005405.1**

(22) Date of filing: **15.03.2007**

(54) **Suppression of high-frequency perturbations in pulse-width modulation**

Unterdrückung von Hochfrequenzstörungen für Pulsweiten-Modulation

Suppression des perturbations haute fréquence dans la modulation de largeur d'impulsion

(84) Designated Contracting States:
**AT BE BG CH CY CZ DE DK EE ES FI FR GB GR HU IE IS IT LI LT LU LV MC MT NL PL PT RO SE SI SK TR**

(43) Date of publication of application:
**17.09.2008 Bulletin 2008/38**

(73) Proprietor: **Harman Becker Automotive Systems GmbH**
**76307 Karlsbad (DE)**

(72) Inventors:
• **Pfaffinger, Gerhard**
**93053 Regensburg (DE)**

• **Knott, Arnold**
**94377 Steinach (DE)**

(74) Representative: **Grünecker Patent- und Rechtsanwälte**
**PartG mbB**
**Leopoldstraße 4**
**80802 München (DE)**

(56) References cited:
**WO-A-00/07291**        **US-A- 4 949 048**
**US-A1- 2002 190 789**    **US-A1- 2005 156 665**

## Description

### Field of Invention

The present invention relates to the technique of pulse-width modulation. In particular, the present invention relates to a method and corresponding circuitry for damping high-frequency perturbations on pulse-width modulation caused by the carrier frequency and its harmonics.

### Background of the invention

Pulse width modulation (PWM) is a powerful technique for controlling analog circuits with digital outputs of a microprocessor or with a discrete modulator. PWM is employed in a wide variety of applications, ranging from measurement and communications to power control and conversion.

PWM is widely used in the common "switch-mode" power supplies that convert AC power to DC for computers and other electronic devices. It can also used to control the speed of a DC motor and the brightness of a light bulb. Particularly important applications of PWM are audio amplifiers configured to generate output signals for cell phone speakers or high-power stereo systems. Due to the fully on/off nature of the PWM output, PWM amplifiers produce less heat than traditional analog amplifiers.

Pulse-width modulation of a signal or power source involves the modulation of its duty cycle to either convey information over a communication channel or control the amount of power sent to some load of an electrical device. Pulse-width modulation uses a square wave whose duty cycle is modulated resulting in the variation of the average value of the waveform. The modulating signal can be recovered from the PWM simply by low-pass filtering.

US 2005/156665 A1 discloses an a class-D amplifier including an operational amplifier and capacitors, which constitute an integrator for integrating a difference between a plus-sided input signal and a minus-sided input signal which constitute analog input signals; delay circuits for delaying a phase of a triangular wave by a desirable very small angle; resistors, which constitute a synthesizing circuit for synthesizing an output of the integrator, the triangular wave, and outputs of the delay circuits with each other; comparators for comparing outputs of the synthesizing circuit with each other; AND circuits which constitute a buffer for inputting outputs of the comparators; and resistors feeding back an output of the buffer to an input side of the integrator.

US 2002/190789 A1 discloses a switching amplifier wherein first and second controllers generate pulse signals whose duty ratio are modulated based on an audio signal and whose frequencies are shifted 180 degree with each other. First and second amplification sections perform switching operation to switching a direct current voltage to generate power-pulse signals whose phases are shifted 180 degree with each other and whose duty ratio are modulated in accordance with the audio signal.

WO 00/07291 A discloses a class D amplifier wherein an audio signal is pulse-modulated in that two sets of switches are adapted to make and break signal paths transferring pulses representing the non-inverted or inverted part of the audio signal, comprise attenuating noise and zero crossing distortion which occur because of crosstalk between modulator and control circuit halves in the amplifier.

US 4 949 048 A discloses a pulse width modulation amplifier circuit includes a comparator which receives an analog signal and generates first and second analog signals having a phase difference of 180 degrees. A phase shifting circuit produces first and second triangular wave carrier signals so as to establish therebetween a phase difference of approximately 90 degrees.

Pulsed modulators are used to transmit information by superposing a high-frequency carrier signal having some carrier frequency and a wanted signal exhibiting some modulation frequency. In order to recover the wanted signal from the transmitted and/or amplified signal the modulated signal is integrated by integration filtering means. These integration filtering means, however, only have finite edges (flanks) to suppress the carrier frequency (see, e.g., "Novel Aspects of an Application of Zero-Ripple Techniques to Basic Converter Topologies", by N. Mohan, F.C. Zach, W. Kolar and H. Sree, in Power Electronics Specialists Conference, 1, 1997). Consequently, high-frequency perturbations, i.e. the carrier frequency and its harmonics, are present in the integrated signal which deteriorate the wanted signal as well as the electromagnetic compatibility of a signal processing means incorporating the pulsed modulator.

It is, therefore, an object of the present invention to provide a method and corresponding circuitry for suppression of high-frequency perturbations in PWM and an improved pulsed electronic circuitry including a pulse modulator with less high-frequency perturbations as compared to the art.

### Description of the Invention

The above-mentioned object is achieved by the method for suppressing high-frequency perturbations in a pulse-width modulation according to claim 1, comprising the steps of pulse-width modulating a first electronic signal by superposing a first carrier signal having a carrier frequency ($f_c$) and an input signal with a first modulation frequency ($f_{m,1}$) to obtain a first pulse-width modulated signal;

pulse-width modulating n second electronic signals, where $n \geq 1$ is an integer, by superposing n second carrier signals having the carrier frequency ($f_c$) with another input signal with a second modulation frequency ($f_{m,2}$), wherein the n second carrier signals are, respectively, phase shifted with respect to the first carrier signal to obtain n second pulse-width modulated signals; low-pass filtering the first pulse-width modulated signal to obtain a first perturbed filtered signal and low-pass filtering the n second pulse-width modulated signals to obtain n second perturbed filtered signals; and

combining the first perturbed filtered signal and the n second perturbed filtered signals by a $C^2SC$ filtering means, wherein $C^2SC$ filtering means denotes a high pass filtering of m-th order or a combination of a high-pass and an all-pass filtering means, and designing the low-pass filtering of the first pulse-width modulated signal and the low-pass filtering of the n second pulse-width modulated signals and the $C^2SC$ filtering to have identically decaying flanks for frequencies higher than the carrier frequency ($f_c$) in order to obtain an enhanced output wanted signal.

The n second carrier signals can, respectively, be phase shifted by 360°/n with respect to the first carrier signal. The above method allows for an enhanced quality of the output signal and an improved electromagnetic compatibility in pulsed synchronized pulse-width modulating circuits. This is achieved by an appropriate phase difference of the used carrier signals resulting in negative perturbations to be superposed on positive ones.

Between the steps of the pulse-width modulating and the low-pass filtering of the modulated signals can, e.g., be transmitted from one device to another. In particular, the signals can be amplified. The combination of the first perturbed filtered signal and the n second perturbed filtered signals to obtain the enhanced output wanted signal can be realized by summation of the signals by a $C^2SC$ high-pass filtering means.

The above method allows for an enhanced quality of the output signal and an improved electromagnetic compatibility in pulsed synchronized pulse-width modulating circuits by a superposition of the perturbation portions of the filtered signals.

The inventive method can be realized by exactly two pulse-width modulating means. Thus, according to a relatively simple and readily built embodiment

one second electronic signal is pulse-width modulated by superposing a second carrier signal having the carrier frequency ($f_c$) and the input signal with the first modulation frequency ($f_{m,\,1}$), wherein the second carrier signal is phase shifted, in particular, by 90° or 180°, with respect to the first carrier signal to obtain a second pulse-width modulated signal; and the method comprises

filtering the first pulse-width modulated signal to obtain a first perturbed filtered signal and filtering the second pulse-width modulated signal to obtain a second perturbed filtered signal; and

combining the first perturbed filtered signal and the second perturbed filtered signal to obtain the enhanced output wanted signal.

In particular, in this embodiment also the first pulse-width modulated signal and the second pulse-width modulated signal are low-pass filtered and in this case the low-pass filtered first pulse-width modulated signal and the low-pass filtered second pulse-width modulated signal, i.e. a first perturbed filtered signal and a second perturbed filtered signal, are combined to obtain the enhanced output wanted signal.

Synchronized coupling of one in-phase clock signal and the corresponding inverted signal or quadrature clock signal results in the desired enhanced quality of the output signal. By inverting phase shifting by 180° and by quadrature phase shifting by 90° degrees is meant, respectively. Phase shifty by other degrees are also possible in accordance with the present invention.

According to the invention, the first perturbed modulated signal and the n second perturbed modulated signals are combined by a $C^2SC$ filtering means to obtain the enhanced output wanted signal. Herein, the term $C^2SC$ filtering means denotes a high pass filtering means of m-th order or a combination of a high-pass and an all-pass filtering means (see detailed description below).

The $C^2SC$ filtering means may have a predetermined (required minimum) damping rate, $\alpha$, for the highest frequency, $f_{max}$, present in the input signal (pass band signal) and wherein the inequation holds $l \geq a\,/\,d \log(f_{max}\,/\,f_c)$ for the length (order) of the $C^2SC$ filtering means, I, with $f_c$ and d denoting the carrier frequency of the carrier signals and the damping rate measured in units of $dB\mu V\,/\,$ decade (damping per order). Numerical simulations have shown that employment of such a $C^2SC$ filtering means results in a superior enhancement of the quality of the filtered (output) wanted signal.

In the method according to one of the above examples the steps of pulse-width modulating the first and the n second electronic signals comprise or consist of processing the first electronic signal in a first pulse-width modulation amplifier to obtain a first amplified pulse-width modulated signal;

processing the n second electronic signals in n second pulse-width modulation amplifiers, respectively, to obtain n second amplified pulse-width modulated signals; and subsequently outputting the first amplified pulse-width modulated signal from first pulse-width modulation amplifier and the n second amplified pulse-width modulated signals from the n second pulse-width modulation amplifiers before low-pass filtering and combining them to obtain the enhanced output wanted signal.

The provided way of suppressing high-frequency perturbations in pulse-width modulation is particularly useful in the context of switching amplifiers, since such amplifiers contain high-frequency energy (switching frequency and it's harmonics) which are partly cancelled by the proposed method.

The above-mentioned object is further achieved by a pulse-width modulation circuitry according to independent claim 5 which is comprising

a clock generation means configured to generate a first carrier signal with a carrier frequency and n second carrier signals, where $n \geq 1$ is an integer, with the carrier frequency ($f_c$), wherein the n second carrier signals are, respectively, phase shifted with respect to the first carrier signal;

a first pulse-width modulation means configured to receive an input signal and to pulse-width modulate the input signal with a first modulation frequency ($f_{m,1}$) and by means of the first carrier signal and to output a first pulse-width modulated signal; n second pulse-width modulation means configured to receive another input signal and to pulse-width modulate the other input signal with a second modulation frequency ($f_{m,2}$) and by means of the n second carrier signals, respectively, and to output n second pulse-width modulated signals; first low-pass filtering means configured to low-pass filter the first pulse-width modulated signal to obtain a first perturbed filtered signal and n second low-pass filtering means configured to low-pass filter the n second pulse-width modulated signals to obtain n second perturbed filtered signals; and a C²SC filtering means configured to combine the first perturbed filtered signal and the n second perturbed filtered signals, wherein C²SC filtering means denotes a high pass filtering of m-th order or a combination of a high-pass and an all-pass filtering means, and wherein the first low-pass filtering means and the n second low-pass filtering means and the C²SC filtering means are designed to have identically decaying flanks for frequencies higher than the carrier frequency (fc) in order to obtain an enhanced output wanted signal.

The first pulse-width modulation means of the herein provided circuitry may comprise a pulse-width modulation amplifier, in particular, a first class D amplifier or switch mode power supply amplifier, and each of the n second pulse-width modulation means comprises a second pulse-width modulation amplifier, in particular, a second class D amplifier or switch mode power supply amplifier.

Employment of a C²SC high-pass filter for the summation of the modulated signals is advantageous, since it avoids affecting the wanted signal that has a significantly lower frequency than the carrier frequency and its harmonics.

The first low-pass filtering means and the second low-pass filtering means and the high-pass filter of m-th order or the combination of a high-pass and all-pass filter can, in particular, be designed to have identically decaying edges (flanks) for frequencies higher than the carrier frequency ($f_c$). Such identical flanks can guarantee optimal destructive superposition of the perturbation portions of the filtered signals.

The present inventions also provides a multichannel sound amplification means, in particular, 9-channel amplification means, comprising the circuitry according to one of the above examples.

Additional features and advantages of the present invention will be described with reference to the drawings. In the description, reference is made to the accompanying figures that are meant to illustrate preferred embodiments of the invention. It is understood that such embodiments do not represent the full scope of the invention.

Figure 1 is a block diagram illustrating suppression of high-frequency perturbations in pulse-width modulation by means of a C²SC filter according to an example of the present invention.

Figure 2 is a schematic diagram illustrating a configuration of a C²SC filter comprising a high-pass filter.

Figure 3 is a schematic diagram illustrating another configuration of a C²SC filter comprising a coupling capacitor.

Figure 4 is a schematic diagram illustrating another configuration of a C²SC filter comprising couplings capacitors.

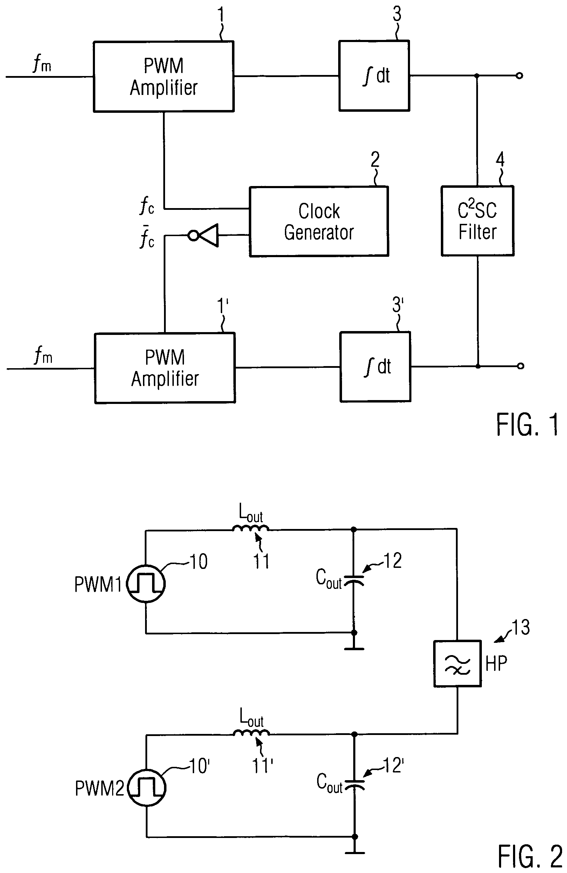

Figure 1 illustrates the inventive method of suppression of high-frequency perturbations in PWM wherein PWM amplifiers 1, 1' are employed. In this example, the PWM amplifiers 1, 1' are switching amplifiers or D amplifiers. In D amplifiers the output transistors are operated as switches. When a transistor is off, the current through it is zero; when it is on, the voltage across it is small, ideally zero. The power dissipation is very low. The input signal is converted to a sequence of pulses whose average value is directly proportional to the amplitude of the signal at that time.

The frequency of the pulses is typically ten or more times the highest frequency of interest in the input signal. The final switching output consists of a train of pulses whose width is a function of the amplitude and frequency of the signal being amplified, and hence these amplifiers are also called PWM amplifiers. The output contains, in addition to the required amplified signal, unwanted spectral components (i.e. the pulse frequency and its harmonics) that must be removed by a passive filter. The filter is usually made with ideally lossless components like inductors and capacitors in order to maintain efficiency.

The PWM amplifiers 1, 1' are controlled by a clock generating means comprising a clock generator 2 for generating a carrier frequency $f_c$ for carrier signals used for the PWM processing and a phase shifting means for shifting the phases of the carrier signals input in the PWM amplifiers 1, 1' with respect to each other (indicated by $\overline{f}_c$). An input signal with a modulation frequency $f_{m,1}$ is input in one of the PWM amplifiers 1 and another input signal with a modulation frequency $f_{m,2}$ is input in another one of the PWM amplifiers 1'. In the PWM amplifiers the carrier signals are superposed by the input signals.

According to the basic idea of the present invention, the amplified and integrated (filtered) PWM signals are to be combined in order to suppress the well-known high-frequency perturbations due to the carrier frequency and its harmonics. The suppression is achieved by destructive superposition of the perturbation portions of the filtered signals output by integration means 3, 3' (see below). Thus, in the present example the PWM amplifier 1' that is shown at the bottom of Figure 1 operates with a carrier signal with a carrier signal with a carrier frequency $f_c$ and phase shifted by 180° with respect to the carrier signal used by the upper PWM amplifier 1. It is noted that whereas in the present example a phase shift by 180° is employed other phase shifts can be realized within the scope of the invention.

The amplified PWM output signals are respectively input in integration means 3, 3'. These integration means 3, 3' are comprised of low-pass filters as known on the art. The outputs of the integration means 3, 3' represent signals comprising the amplified wanted signal as well as high-frequency perturbations due to the carrier signal. These signals output by the integration means 3, 3' are combined by processing by a $C^2SC$ filter 4 to cancel out the perturbation portions.

In other words, for a wanted signal that is pulse-width modulated by a PWM amplifier 1 an additional modulated signal with corresponding negative perturbations after the respective filtering of both signals is added in the $C^2SC$ filter 4 in order to achieve cancellation of the high-frequency perturbations at frequencies of the carrier frequency and its harmonics.

An example for the employed $C^2SC$ filter 4 of Figure 1 is shown in Figures 2, 3 and 4. The filter of Figure 2 includes clock rate processing means 10, 10' (PWMs based on clocks $f_c$ and $\overline{f_c}$, respectively) in order to achieve a synchronized pulsed coupling of the output signals of the integration means 3, 3'. Summation of the output signals of the integration means 3, 3' that exhibit opposite phases is performed by means of output inductances 11, 11', output capacitors 12, 12' and a high pass filter 13.

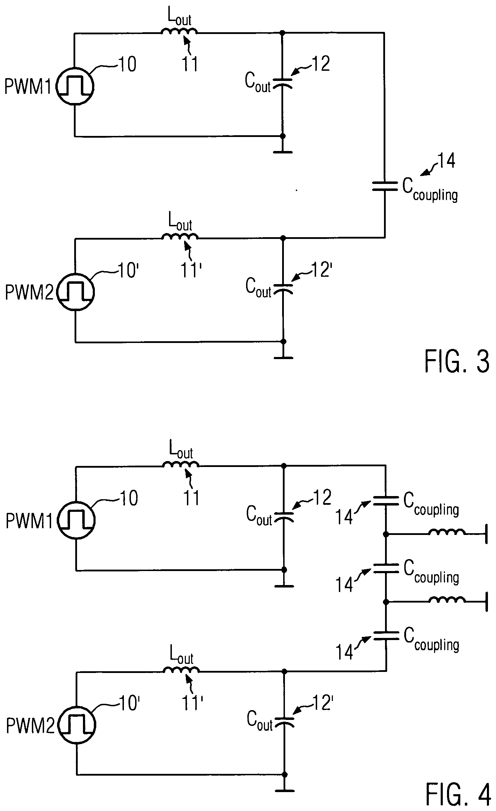

According to Figure 3 the $C^2SC$ filter includes clock rate processing means 10, 10' (PWMs based on clocks $f_c$ and $\overline{f_c}$, respectively) in order to achieve a synchronized pulsed coupling of the output signals of the integration means 3, 3'. In this example, the high pass filter 13 of Figure 2 is replaced by a coupling capacitor 14. As illustrated in Figure 4, alternatively, a number of coupling capacitors rather than one coupling capacitor can be provided.

All previously discussed embodiments are not intended as limitations but serve as examples illustrating features and advantages of the invention. It is to be understood that some or all of the above described features can also be combined in different ways according to the scope as defined by the appended set of claims.

## Claims

1. Method for suppressing high-frequency perturbations in a pulse-width modulation, comprising the steps of
pulse-width modulating by superposing a first carrier signal having a carrier frequency ($f_c$) and an input signal with a first modulation frequency ($f_{m, 1}$) to obtain a first pulse-width modulated signal;
pulse-width modulating n second electronic signals, where $n \geq 1$ is an integer, by superposing n second carrier signals having the carrier frequency ($f_c$) with another input signal with a second modulation frequency ($f_{m, 2}$), wherein the n second carrier signals are, respectively, phase shifted with respect to the first carrier signal to obtain n second pulse-width modulated signals; low-pass filtering the first pulse-width modulated signal to obtain a first perturbed filtered signal and low-pass filtering the n second pulse-width modulated signals to obtain n second perturbed filtered signals; and **characterized by** combining the first perturbed filtered signal and the n second perturbed filtered signals by a $C^2SC$ filtering means (4), wherein $C^2SC$ filtering means denotes a high pass filtering of m-th order or a combination of a high-pass and an all-pass filtering means, and designing the low-pass filtering of the first pulse-width modulated signal and the low-pass filtering of the n second pulse-width modulated signals and the $C^2SC$ filtering to have identically decaying flanks for frequencies higher than the carrier frequency ($f_c$) in order to obtain an enhanced output wanted signal.

2. The method according to one of the preceding claims, wherein n equals one and the second electronic signal is pulse-width modulated by superposing the second carrier signal having the carrier frequency ($f_c$) and the input signal with the first modulation frequency ($f_{m, 1}$), wherein the second carrier signal is phase shifted by 90° or 180° with respect to the first carrier signal to obtain the second pulse-width modulated signal.

3. The method according to claim 1, wherein the $C^2SC$ filtering means has a predetermined damping rate, a, for the highest frequency, $f_{max}$, present in the input signal and wherein the inequation holds

$$l \geq \alpha / d \log(f_{max} / f_c)$$

for the length of the $C^2SC$ filtering means, l, with $f_c$ and d denoting the carrier frequency of the carrier signals and the damping rate measured in units of $dB\mu V$ / decade.

4. The method according to one of the preceding claims, wherein the steps of pulse-width modulating the first and the n second electronic signals comprise or consist of processing the first electronic signal in a first pulse-width modulation amplifier (1) to obtain a first amplified pulse-width modulated signal; processing the n second electronic signals in n second pulse-width modulation amplifiers (1'), respectively, to obtain n second amplified pulse-width modulated signals; and

subsequently outputting the first amplified pulse-width modulated signal from first pulse-width modulation amplifier (1) and the n second amplified pulse-width modulated signals from the n second pulse-width modulation amplifiers (1') before low-pass filtering and combining them to obtain the enhanced output wanted signal.

5. Pulse-width modulation circuitry comprising a clock generation means (2) configured to generate a first carrier signal with a carrier frequency and n second carrier signals, where n $\geq$ 1 is an integer, with the carrier frequency ($f_c$), wherein the n second carrier signals are, respectively, phase shifted with respect to the first carrier signal; a first pulse-width modulation means configured to receive an input signal and to pulse-width modulate the input signal with a first modulation frequency ($f_{m, 1}$) and by means of the first carrier signal and to output a first pulse-width modulated signal; n second pulse-width modulation means configured to receive another input signal and to pulse-width modulate the other input signal with a second modulation frequency ($f_{m, 2}$) and by means of the n second carrier signals, respectively, and to output n second pulse-width modulated signals; first low-pass filtering means (3, 3') configured to low-pass filter the first pulse-width modulated signal to obtain a first perturbed filtered signal and n second low-pass filtering means configured to low-pass filter the n second pulse-width modulated signals to obtain n second perturbed filtered signals; and **characterized by** a $C^2SC$ filtering means (4) configured to combine the first perturbed filtered signal and the n second perturbed filtered signals, wherein $C^2SC$ filtering means denotes a high pass filtering of m-th order or a combination of a high-pass and an all-pass filtering means, and wherein the first low-pass filtering means and the n second low-pass filtering means and the $C^2SC$ filtering means are designed to have identically decaying flanks for frequencies higher than the carrier frequency ($f_c$) in order to obtain an enhanced output wanted signal.

6. The circuitry according to claim 5, wherein the first pulse-width modulation means comprises a first pulse-width modulation class D amplifier or a first switch mode power supply amplifier, and each of the n second pulse-width modulation means comprises a second pulse-width modulation class D amplifier or a second switch mode power supply amplifier.

7. 9-channel amplification means comprising the circuitry according to one of the claims 5 to 6.

**Patentansprüche**

1. Verfahren zum Unterdrücken von Hochfrequenzstörungen in einer Pulsweiten-Modulation, das die folgenden Schritte umfasst:

Pulsweiten-Modulieren durch Überlagern eines ersten Trägersignals, das eine Trägerfrequenz ($f_c$) aufweist, und eines Eingangssignals mit einer ersten Modulationsfrequenz ($f_{m, 1}$), um ein erstes pulsweitenmoduliertes Signal zu erhalten;
Pulsweiten-Modulieren von n zweiten elektronischen Signalen, wobei n $\geq$ 1 eine ganze Zahl ist, durch Überlagern von n zweiten Trägersignalen, welche die Trägerfrequenz ($f_c$) aufweisen, mit einem anderen Eingangssignal mit einer zweiten Modulationsfrequenz ($f_{m, 2}$), wobei die n zweiten Trägersignale jeweils in Bezug auf das erste Trägersignal phasenverschoben sind, um n zweite pulsweitenmodulierte Signale zu erhalten;
Tiefpassfiltern des ersten pulsweitenmodulierten Signals, um ein erstes gestörtes gefiltertes Signal zu erhalten, und Tiefpassfiltern der n zweiten pulsweitenmodulierten Signale, um n zweite gestörte gefilterte Signale zu erhalten; und
**gekennzeichnet durch**
Kombinieren des ersten gestörten gefilterten Signals mit den n zweiten gestörten gefilterten Signalen durch eine $C^2SC$-Filtereinrichtung (4), wobei die $C^2SC$-Filtereinrichtung ein Hochpassfiltern der mten Ordnung bezeichnet, oder eine Kombination aus einer Hochpassfilter- und einer Allpassfiltereinrichtung, und Gestalten des Tiefpassfilterns des ersten pulsweitenmodulierten Signals und des Tiefpassfilterns der n zweiten pulsweitenmodulierten Signale und des $C^2SC$-Filterns, um identische abfallende Flanken für Frequenzen aufzuweisen, die höher sind als die Trägerfrequenz ($f_c$), um ein verbessertes Nutzausgangssignal zu erhalten.

2. Verfahren nach einem der vorangehenden Ansprüche, wobei n Gleiche und das zweite elektronische Signal pulsweitenmoduliert werden, indem das zweite Trägersignal, das die Trägerfrequenz ($f_c$) aufweist, und das Eingangssignal mit der ersten Modulationsfrequenz ($f_{m, 1}$) überlagert werden, wobei das zweite Trägersignal in Bezug auf das erste Trägersignal um 90° oder 180° phasenverschoben ist, um das zweite pulsweitenmodulierte Signal zu erhalten.

3. Verfahren nach Anspruch 1, wobei die $C^2SC$-Filtereinrichtung eine vorbestimmte Dämpfungsrate $\alpha$ für die höchste Frequenz $f_{max}$ aufweist, die in dem Eingangssignal vorhanden ist, wobei die folgende Ungleichung für die Länge der C²SC-Filtereinrichtung l gilt:

$$l \geq \alpha \; / \; d \; \log(f_{max}/f_c),$$

wobei $f_c$ und d die Trägerfrequenz der Trägersignale und die Dämpfungsrate anzeigen, die in Einheiten von dBμV/Jahrzehnt gemessen werden.

4. Verfahren nach einem der vorangehenden Ansprüche, wobei die Schritte des Pulsweitenmodulierens des ersten und der n zweiten elektronischen Signale Folgendes umfassen oder daraus bestehen:

Verarbeiten des ersten elektronischen Signals in einem ersten Pulsweitenmodulationsverstärker (1), um ein erstes verstärktes pulsweitenmoduliertes Signal zu erhalten;
Verarbeiten der n zweiten elektronischen Signale jeweils in n zweiten Pulsweitenmodulationsverstärkern (1'), um n zweite verstärkte pulsweitenmodulierte Signale zu erhalten; und
nachfolgendes Ausgeben des ersten verstärkten pulsweitenmodulierten Signals von dem ersten Pulsweitenmodulationsverstärker (1) und der n zweiten verstärkten pulsweitenmodulierten Signale von den n zweiten Pulsweitenmodulationsverstärkern (1') vor dem Tiefpassfiltern und Kombinieren dieser, um das verbesserte Nutzausgangssignal zu erhalten.

5. Pulsweitenmodulationsschaltung, umfassend:

eine Takterzeugungseinrichtung (2), die konfiguriert ist, um ein erstes Trägersignal mit einer Trägerfrequenz und n zweite Trägersignale mit der Trägerfrequenz ($f_c$) zu erzeugen, wobei n ≥ 1 eine ganze Zahl ist, wobei die n zweiten Trägersignale jeweils in Bezug auf das erste Trägersignal phasenverschoben sind;
eine erste Pulsweitenmodulationseinrichtung, die konfiguriert ist, um ein Eingangssignal zu empfangen und um mithilfe des ersten Trägersignals eine Pulsweitenmodulation mit einer ersten Modulationsfrequenz ($f_{m,1}$) an dem Eingangssignal vorzunehmen und um ein erstes pulsweitenmoduliertes Signal auszugeben;
n zweite Pulsweitenmodulationseinrichtungen, die konfiguriert sind, um ein weiteres Eingangssignal zu empfangen und um mithilfe der n zweiten Trägersignale jeweils eine Pulsweitenmodulation mit einer zweiten Modulationsfrequenz ($f_{m,2}$) an den n zweiten Eingangssignalen vorzunehmen und um n zweite pulsweitenmodulierte Signale auszugeben;
eine erste Niederpassfiltereinrichtung (3, 3'), die konfiguriert ist, um eine Niederpassfilterung an dem ersten pulsweitenmodulierten Signal vorzunehmen, um ein erstes gestörtes gefiltertes Signal zu erhalten, und n zweite Niederpassfiltereinrichtungen, die konfiguriert sind, um eine Niederpassfilterung an den n zweiten pulsweitenmodulierten Signalen vorzunehmen, um n zweite gestörte gefilterte Signale zu erhalten;
und **gekennzeichnet durch**:
eine C²SC-Filtereinrichtung (4), die konfiguriert ist, um das erste gestörte gefilterte Signal mit den n zweiten gestörten gefilterten Signalen zu kombinieren, wobei die C²SC-Filtereinrichtung ein Hochpassfiltern der mten Ordnung bezeichnet, oder eine Kombination aus einer Hochpassfiltereinrichtung und einer Allpassfiltereinrichtung, und wobei die Tiefpassfiltereinrichtung und die n zweiten Tiefpassfiltereinrichtungen und die C²SC-Filtereinrichtung gestaltet sind, um identische abfallende Flanken für Frequenzen aufzuweisen, die höher sind als die Trägerfrequenz ($f_c$), um ein verbessertes Nutzausgangssignal zu erhalten.

6. Schaltung nach Anspruch 5, wobei die erste Pulsweitenmodulationseinrichtung einen ersten Pulsweitenmodulationsverstärker der Klasse D oder einen ersten Schaltnetzteilverstärker umfasst und jede der n zweiten Pulsweitenmodulationseinrichtungen einen zweiten Pulsweitenmodulationsverstärker der Klasse D oder einen zweiten Schaltnetzteilverstärker umfasst.

7. 9-Kanal-Verstärkungseinrichtung, welche die Schaltung nach einem der Ansprüche 5 bis 6 umfasst.

**Revendications**

1. Procédé de suppression de perturbations haute fréquence dans une modulation d'impulsions en largeur, comprenant les étapes de
modulation d'impulsions en largeur en superposant un premier signal porteur ayant une fréquence porteuse ($f_c$) et un signal d'entrée avec une première fréquence de modulation ($f_{m,1}$) pour obtenir un premier signal à modulation d'impulsions en largeur ;
modulation d'impulsions en largeur de n seconds signaux électroniques, où n ≥ 1 est un nombre entier, en superposant n seconds signaux porteurs ayant la fréquence porteuse ($f_c$) avec un autre signal d'entrée avec une seconde fréquence de modulation ($f_{m,2}$), dans lequel les n seconds signaux porteurs sont respectivement déphasés par rapport au premier signal porteur pour obtenir n seconds signaux à modulation d'impulsions en largeur ;
filtrage passe-bas du premier signal à modulation d'impulsions en largeur pour obtenir un premier signal filtré perturbé et filtrage passe-bas des n seconds signaux à modulation d'impulsions en largeur pour obtenir n seconds signaux filtrés perturbés ; et **caractérisé par**

la combinaison du premier signal filtré perturbé et des n seconds signaux filtrés perturbés par un moyen de filtrage C$^2$SC (4), dans lequel le moyen de filtrage C$^2$SC indique un filtrage passe-haut de m$^{ième}$ ordre ou une combinaison d'un moyen de filtrage passe-haut et passe-tout, et la conception du filtrage passe-bas du premier signal à modulation d'impulsions en largeur et du filtrage passe-bas des n seconds signaux à modulation d'impulsions en largeur et le filtrage C$^2$SC pour avoir des flancs de descente identiques pour des fréquences plus hautes que la fréquence porteuse ($f_c$) afin d'obtenir un signal voulu de sortie amélioré.

2. Procédé selon l'une des revendications précédentes, dans lequel n est égal à un et le second signal électronique subit une modulation d'impulsions en largeur en superposant le second signal porteur ayant la fréquence porteuse ($f_c$) et le signal d'entrée avec la première fréquence de modulation ($f_{m,1}$), dans lequel le second signal porteur est déphasé de 90° ou 180° par rapport au premier signal porteur pour obtenir le second signal à modulation d'impulsions en largeur.

3. Procédé selon la revendication 1, dans lequel le moyen de filtrage C$^2$SC a un taux d'amortissement prédéterminé, $\alpha$, pour la fréquence la plus haute, $f_{max}$, présente dans le signal d'entrée et dans lequel l'inéquation est vérifiée par

$$l \geq \alpha/d \ \log(f_{max}/f_c)$$

pour la longueur du moyen de filtrage C$^2$SC, l, avec $f_c$ et d indiquant la fréquence porteuse des signaux porteurs et le taux d'amortissement mesuré dans des unités de dBµV/décade.

4. Procédé selon l'une des revendications précédentes, dans lequel les étapes de modulation d'impulsions en largeur du premier et des n seconds signaux électroniques comprennent ou consistent en le traitement du premier signal électronique dans un premier amplificateur de modulation d'impulsions en largeur (1) pour obtenir un premier signal à modulation d'impulsions en largeur amplifié ; le traitement des n seconds signaux électroniques dans n seconds amplificateurs de modulation d'impulsions en largeur (1'), respectivement, pour obtenir n seconds signaux à modulation d'impulsions en largeur amplifiés ; et la fourniture en sortie ensuite du premier signal à modulation d'impulsions en largeur amplifié à partir du premier amplificateur de modulation d'impulsions en largeur (1) et des n seconds signaux à modulation d'impulsions en largeur amplifiés à partir des n seconds amplificateurs de modulation d'impulsions en largeur (1') avant le filtrage passe-bas et leur combinaison pour obtenir le signal voulu de sortie amélioré.

5. Circuiterie de modulation d'impulsions en largeur comprenant
un moyen de génération d'horloge (2) configuré pour générer un premier signal porteur avec une fréquence porteuse et n seconds signaux porteurs, où n ≥ 1 est un nombre entier, avec la fréquence porteuse ($f_c$), dans laquelle les n seconds signaux porteurs sont respectivement déphasés par rapport au premier signal porteur ;
un premier moyen de modulation d'impulsions en largeur configuré pour recevoir un signal d'entrée et pour effectuer une modulation d'impulsions en largeur sur le signal d'entrée avec une première fréquence de modulation ($f_{m,1}$) et au moyen du premier signal porteur et pour fournir en sortie un premier signal à modulation d'impulsions en largeur ;
n seconds moyens de modulation d'impulsions en largeur configurés pour recevoir un autre signal d'entrée et pour effectuer une modulation d'impulsions en largeur sur l'autre signal d'entrée avec une seconde fréquence de modulation ($f_{m,2}$) et au moyen des n seconds signaux porteurs, respectivement, et pour fournir en sortie n seconds signaux à modulation d'impulsions en largeur ;
un premier moyen de filtrage passe-bas (3, 3') configuré pour effectuer un filtrage passe-bas du premier signal à modulation d'impulsions en largeur pour obtenir un premier signal filtré perturbé et n seconds moyens de filtrage passe-bas configurés pour effectuer un filtrage passe-bas des n seconds signaux à modulation d'impulsions en largeur pour obtenir n seconds signaux filtrés perturbés ; et **caractérisée par**
un moyen de filtrage C$^2$SC (4) configuré pour combiner le premier signal filtré perturbé et les n seconds signaux filtrés perturbés, dans laquelle le moyen de filtrage C$^2$SC indique un filtrage passe-haut de m$^{ième}$ ordre ou une combinaison d'un moyen de filtrage passe-haut et passe-tout, et dans laquelle le premier moyen de filtrage passe-bas et les n seconds moyens de filtrage passe-bas et le moyen de filtrage C$^2$SC sont conçus pour avoir des flancs de descente identiques pour des fréquences plus hautes que la fréquence porteuse ($f_c$) afin d'obtenir un signal voulu de sortie amélioré.

6. Circuiterie selon la revendication 5, dans laquelle le premier moyen de modulation d'impulsions en largeur comprend un premier amplificateur de classe D de modulation d'impulsions en largeur ou un premier amplificateur d'alimentation électrique à mode de commutation, et chacun des n seconds moyens de modulation d'impulsions en largeur comprend un second amplificateur de classe D de modulation d'impulsions en largeur ou un second amplificateur d'alimentation électrique à mode de commutation.

7. Moyen d'amplification à 9 voies comprenant la circuiterie selon l'une des revendications 5 et 6.

FIG. 1

FIG. 2

FIG. 3

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2005156665 A1
- US 2002190789 A1
- WO 0007291 A
- US 4949048 A

**Non-patent literature cited in the description**

- **N. MOHAN ; F.C. ZACH ; W. KOLAR ; H. SREE.** Novel Aspects of an Application of Zero-Ripple Techniques to Basic Converter Topologies. *Power Electronics Specialists Conference,* 1997, 1